# EUROPEAN PATENT SPECIFICATION

(11) **EP 4 016 001 B1**
(45) Date of publication and mention of the grant of the patent: **03.12.2025**
(21) Application number: 21198443.0
(22) Date of filing: 23.09.2021
(51) Int. Cl.: G06Q 10/047, G01C 21/34, G06Q 10/10, G06Q 10/04

(54) **FLEET EMISSION CONTROL, DISTRIBUTION, AND LIMITS ADHERENCE**
EINHALTUNG VON FLOTTENEMISSIONSKONTROLLEN, -VERTEILUNG UND -BEGRENZUNG
CONTRÔLE DES ÉMISSIONS, DISTRIBUTION ET RESPECT DES LIMITES DE FLOTTES

(30) Priority: 21.12.2020 US 202017129759
(43) Date of publication of application: 22.06.2022
(73) Proprietor: INTEL Corporation, Santa Clara, CA 95054 (US)
(72) Inventor: FOX, Maik, 76287 Rheinstetten (DE); POHL, Daniel, 91093 Heßdorf (DE)
(74) Representative: 2SPL Patentanwälte PartG mbB

(56) References cited:
- WO-A1-2015/177495
- US-A1- 2020 242 858

## Description

### FIELD OF THE DISCLOSURE

The present subject matter relates to emissions control for vehicles. Specifically, the present disclosure relates to emission control, distribution, and limits adherence for one or more vehicles.

### BACKGROUND

Patent document (US 2020/242858 A1) proposes a transportation mobility system including a data storage configured to maintain vehicle data indicating fuel consumption and count of passengers for vehicles of a transportation system, and user data describing movements of the passengers within the transportation system. The system also includes an emissions monitoring portal, programmed to provide, for vehicles of a fleet, estimates of pollutant emissions for the fleet and a percent share of miles completed by zero-emissions transportation for the fleet.

Patent document (WO 2015/177495 A1) proposes a vehicle guidance system for a vehicle travelling from an origin to a destination with at least one intermediate waypoint, the guidance system providing instructions for guiding the vehicle from the origin, via the waypoint, to the destination along a route selected such that CO₂ emissions from the vehicle are minimised. At one or more waypoints along the route, payloads may be picked up by the vehicle or set down from the vehicle, varying its cargo payload. The guidance system may take account of the varying vehicle payload in selecting the order in which waypoints are visited, and the route taken between waypoints.

Currently, the manufacturers of vehicles, such as passenger vehicles, large commercial vehicles, etc., are required to meet emissions standards set forth by governing bodies. Emissions standards are put in place to limit greenhouse gas production and help reduce an impact vehicles may have on the environment. For example, passenger vehicles, such as cars, may be required to have a specified fuel economy to limit the amount of CO₂ and nitrogen compounds released into the atmosphere.

### BRIEF DESCRIPTION OF THE FIGURES

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 shows an example emissions map in accordance with at least one example of this disclosure.
FIG. 2 shows an example schematic for emission control, distribution, and limits adherence in accordance with at least one example of this disclosure.
FIG. 3 shows a method for generating and/or updating an emissions model in accordance with at least one example of this disclosure.
FIG. 4 shows a method for trip planning in accordance with at least one example of this disclosure.
FIG. 5 shows a method for determining emissions in accordance with at least one example of this disclosure.
FIG. 6 shows a method for predicting emissions in accordance with at least one example of this disclosure.
FIG. 7 shows a block diagram illustrating an example machine upon which any one or more of the techniques (e.g., methodologies) discussed herein may perform in accordance with at least one example of this disclosure.

### DETAILED DESCRIPTION

Vehicles used for mobility as a service (MaaS) may use a mixture of different propulsion methods (e.g., internal combustion engines, battery electric vehicles, hybrids, hydrogen electric vehicles, etc.). With emission limits continuously being tightened and applied to fleet operators, groups of MaaS vehicles, sometimes referred to as a fleet or fleets, may need to manage emissions to keep availability of the services as high as possible. As disclosed herein MaaS may encompass robotaxis, robobuses, autonomous vehicle on demand services, ride sharing services, etc.

In addition to emissions limits in normally in effect, emissions limits may also be dynamic and thus, the ability to manage emissions may be dynamic as well to allow the MaaS fleet to remain in operation. For example, during a smog alarm or unsafe air restrictions, there may be a need to dynamically adjust emissions for the fleet to avoid service outages.

Emissions of internal combustion engines (ICE) are under strict legal control, and the limits are continuously being lowered. As disclosed herein, real time data of the emissions from vehicles within cities may be dynamically controlled. This may be done by limiting vehicles within parts of a city that might be already closed off to vehicles not fulfilling certain emissions standards. For example, some cities in Germany have roads closed for vehicles not fulfilling the latest emissions standards.

Due to the responsibility and the economical operation of a MaaS fleet, a mix of propulsion methods and respective ranges and refueling/recharging needs may be present. To ensure a high level of service availability, the operator the systems and methods disclosed herein may be proactively employed to control a fleet's emissions, to distribute the emissions over a larger area, and to otherwise adhere to legal limits.

The systems and methods disclosed herein may consider not only local emissions, but also total emissions, sometimes called overall emissions. For example, for EVs, the local emissions may be limited to tire and break wear, but the total emissions may include the generations of electricity needed to charge the EV's batteries. For example, if an EV is charged with electricity generated by a power plant that burns a fossil fuel, the total emissions may be different that if the same EV is charged via solar power plants, hydrogen processing, etc. As disclosed herein, recharging and refueling planning may select and account for the emissions of the energy medium (e.g., coal, wind, solar, etc.) used to create the electricity used to charge an EV. This data may be used to simulate the emissions while driving either with "dirty" sources, such as coal, or "clean" sources, such as solar or wind.

Using the systems and methods disclosed herein, dynamic changes in allowed emissions may be monitored and the fleet's emissions distribution over a city may be managed. For example, if the MaaS is a passenger carrying car serve with a fleet of vehicles, the fleet's emissions may be monitored and controlled to allow for passenger pick up and drop off in an area with dynamically changing emissions with minimized impact.

Fleet management and route planning using the systems and methods disclosed herein may ensure vehicles are suitable for a trip planned and their operations do not impact the operation of other vehicles in the fleet. For example, the fleet management and route planning may allow for vehicles to travel without triggering an emissions limit by operating too many vehicles of the same kind in the same area.

As disclosed herein, a MaaS fleet operator may monitor the actual fleet's emissions and proactively manage the emissions by dispatching vehicles and vehicles' operation modes accordingly. Real-time models and data may be used to allow for the dynamic management of emissions to allow Mass fleets to operate within regulation and limits. The real-time emissions distribution model and multi-modal planning methods disclosed herein may extend to vehicle operations and selections as well.

The above discussion is intended to provide an overview of subject matter of the present patent application. It is not intended to provide an exclusive or exhaustive explanation. The description below is included to provide further information.

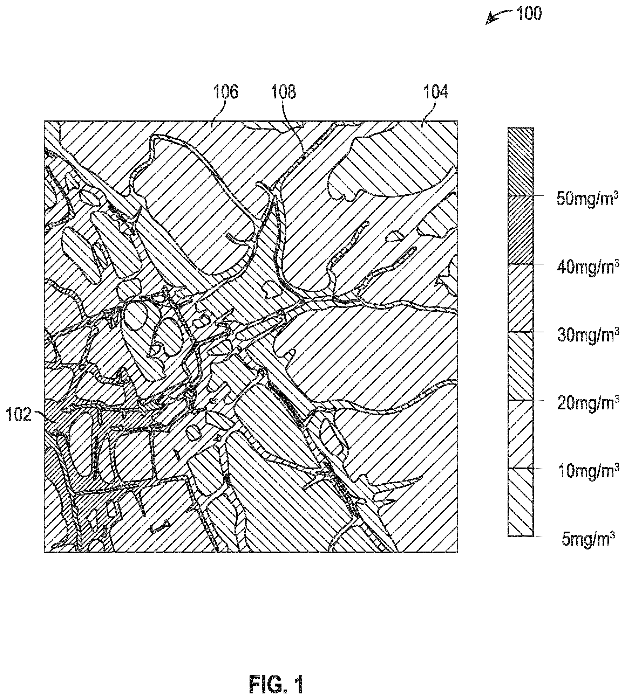

Turning now to the figures, FIG. 1 shows an example emissions map 100 in accordance with at least one example of this disclosure. As shown in FIG. 1, emissions map 100 may provide a visual representation of areas within a geographic location of particle density of pollutants. For example, a first area 102 may be located in a high traffic area, such as proximate a city center or other areas with large volumes of traffic. A second area 104 may be located in an area of low traffic, such as suburbs surrounding first area 102.

First area 102 may have high concentrations, such as greater than 50mg/m³ while second area 104 may have lower concentrations, such as between 5 and 10 mg/m³. In addition to areas, emissions map 100 may also depict corridors or other areas of localized emissions concentrations. For example, a third area 106 may have an overall particle density of between 10 and 20 mg/m³, but a corridor 108, which may coincide with the location of a road or other infrastructure where vehicles may be concentrated, may have a particle density of between 20 and 30 mg/m³. Using emissions maps, such as emissions map 100, managers of fleet vehicles may identify areas were emissions may exceed a limit set by regulations and plan accordingly to reduce and/or distribute emissions.

While FIG. 1 shows a static image, emissions map 100 may be a dynamic image displayed on a display and updated in real-time. For example, sensors located throughout the area covered by emissions map 100 may continuously monitor particle levels and provide the data to a central system. In addition to sensors located throughout the area, the vehicles, fleet or otherwise, may include sensors that measure emissions and/or particle densities in proximity to the vehicles. The emissions and particle densities measured by the vehicles may also be transmitted to the central system. The central system may then update emissions map 100 in real-time using the data.

The sensors located throughout the area may be managed by a governing body and/or the other entities, such a local news outlet, that may monitor and report on air quality. For example, using the data provided by the sensors, a local news outlet may report on when smog is high to alert citizens. Using the data, streets may be closed for vehicles not fulfilling the emission requirements.

As disclosed herein, as emission controls become stricter and more dynamic, real-time emissions data may be used to plan trips, distribute emissions from vehicles, and/or switch between vehicle modes. For example, using the systems and methods disclosed herein emissions may be monitored and control to allow for a switch in propulsion methods from internal combustion engines to hybrid and/or electric only so that the fleet of vehicles does not exceed legal limits.

Using the data from the vehicles the operator of a fleet may develop models for its vehicles and take local emissions into account. These models may include not only vehicle data, but may also include environmental data such as temperature, rainfall, etc. The environmental data may be past recorded data and/or forecasts for expected environmental conditions the vehicles may encounter during operations. Switching their propulsion methods may be dependent on locations of charge points for EVs, the actual trip planned by the passenger, and battery state of charge.

When limits are exceeded vehicles with higher emissions may be redirected and lower emissions vehicles, such as EVs, may be redirected accordingly. Using the forecasted data, a fleet management system may forecast times of high emissions and proactively reroute vehicles to pre-empt exceeding emissions limits. As disclosed herein, a multitude of components of the MaaS service may work together and exchange data.

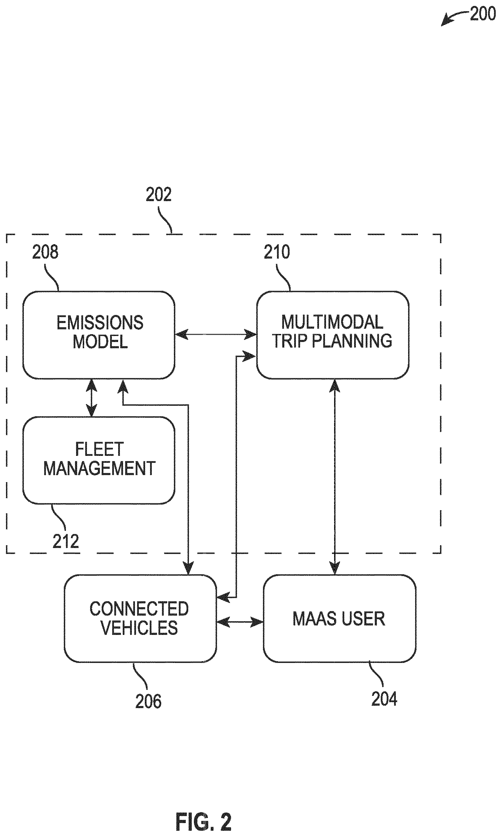

FIG. 2 shows an example schematic for a system 200 for emission control, distribution, and limits adherence in accordance with at least one example of this disclosure. System 200 may include a computing system 202, a MaaS user 204, and connected vehicles 206. Computing system 202 may include an emissions model 208, a multimodal trip planning module 210, and a fleet management model 212.

MaaS user 204 may include individuals that utilize MaaS via connected vehicles 206. For example, MaaS user 204 may include customers of ride sharing services. MaaS user 204 may include those that operate connected vehicles 206. MaaS user 204 may be a shipping company that operates a fleet of vehicles. Thus, the ultimate end user that utilizes connected vehicles 206 may be entities that contract with the operator of connected vehicles.

Connected vehicles 206 may be any vehicle that is part of a fleet of vehicles. Connected vehicles 206 may include vehicles that provide different modalities for travel. For example, connected vehicles 206 may include, but is not limited to, automobiles, buses, carriages, drones, airplanes, ships, trains, etc. Connected vehicles 206 may allow MaaS user 204 to travel from an origination to a destination via one or more of the vehicles that comprise connected vehicles 206.

Emissions model 208 may include data for use in trip planning as well as modeling emissions of the connected vehicles 206. For example, emissions model 208 may include environmental data such as past and forecasted weather data. Emissions model 208 may include performance data for each of connected vehicles 206. Using the weather data and the performance data, computing system 202 may determiner performance of each of connected vehicles 206 to account for things such as engine and/or battery performance at various temperatures. For example, internal combustion engines generally operate at higher efficiencies in colder weather and batteries, generally have lower performance at cold temperature. Thus, models for a delivery truck that has an internal combustion engine may show reduced emissions during winter months than in summer months. An electric vehicle with a lithium-ion battery may be modeled to show a reduced range in winter months.

Emissions model 208 may also include wear data for each of connected vehicles 206. For example, as engines, tires, and/or other components wear, their performance may decrease thereby causing more emissions. Emissions model 208 may include weighting factors and/or other equations to account for vehicle wear.

Emissions model 208 may also include emissions budget data. An emission budget may be an overall emissions budget (sometimes referred to as a total emissions) and/or localized emissions budgets, component emissions budgets, etc. Local emissions may include, but is not limited to, emissions for exhaust, tire wear, windshield washer fluid, coolant leakage, and emissions for generating the energy to power the vehicle (i.e., emissions from a power plant, oil refinery, etc.). Primary emissions may be, for example, emissions of power plants or plants for hydrogen generation.

Localized emissions budgets may be emissions limits established for certain areas and/or certain vehicles. For example, a municipality may establish emissions limits for an inner-city area that differs from an emissions limit for a suburban area. The emissions limit may be a total emissions limit for all vehicles in the municipality and/or for specific limits for various types of vehicles. For instance, the municipality may establish an emissions limit for diesel vehicles that differs from an emissions limit established for EVs.

A component emissions budget may include limits for various types of emissions. For example, a component emissions budget may limit the emissions from tire wear in areas where rain may cause the rubber to wash into local waterways, such as lakes and/or rivers.

Budget data, emission or otherwise, may also include monetary budgets. For example, the emissions budget may set a fine or other penalty for exceeding an emissions limit. Budget data may include a monetary budget for operation of connected vehicles 206. Thus, a user may elect to exceed an emissions budget and pay a fine or other penalty. Therefore, emissions model 208 may factor in violations of emissions standards used to define emissions budgets.

Computing system 202 may be part of a cloud or distributed edge computing system and thus, emissions model 208 may be stored and computed at a data center. The input data for emissions model 208 may be collected from many sources. Non-limiting examples of data sources for emissions model 208 include all fleet vehicles (i.e., connected vehicles 206), stationary sensors, government data, and weather reports and forecasts. After data collection and during operation of connected vehicles 206, emissions model 208 may be updated. The data may be displayed as a map, such as emissions map 100, annotating the data and/or using various symbols and colors to present the data. Depending on the goals of the MaaS provider and the legal limits, local and primary emissions may be modeled and budgeted.

As disclosed herein the granularity of data collection and/or presentation may be varied from suburbs, blocks, lengths of road, intersections, and/or even in a fine grid, depending on data sources and computational power/data storage available. Emissions model 206 may also factor in the decay of the emissions. For example, the weather may play a role in emissions decay. For instance, wind, and rain may carry emissions from one area to another. Thus, while one area may not have much vehicle traffic, the wind and/or rain may carry emissions from other areas into the area, thus causing an increase in emission that may be accounted for using emissions model 208.

When emissions model 208 is updated and decay is calculated, an emissions budget may be computed and updated. For example, during operation of the connected vehicles, the emissions budget may be updated and the remaining emissions allowed at the moment may be displayed and/or used to plan future trips, routes, divert existing routes, etc. From this budget, current operations of connected vehicles 206 may be subtracted (e.g., emissions prediction per vehicle and/or trip planned). This budget prediction may be used for multimodal trip planning as disclosed herein.

As disclosed herein, one source of data may be connected vehicles 206. Data from connected vehicles 206 may be sourced from on-board control units, as they already may have relevant parameters and values readily available. Emissions data may also be estimated by tracking the state of charge and/or fuel tank status.

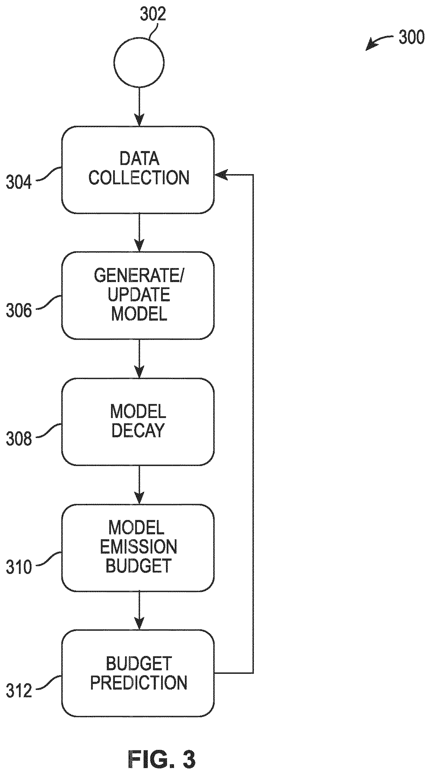

FIG. 3 shows a method 300 for generating and/or updating emissions model 208. Method 300 may begin at stage 302 and proceed to stage 304 where data may be collected. As disclosed herein the data may be received by computing system 202. The data may be received from sensors located in an area, such as distributed throughout a city. The data may also be received from remote computing devices. For example, the data may be weather data, updates to emissions standards and/or regulations, etc. and may be received from official sources that maintain the data.

Data may also be received from connected vehicles 206 as disclosed herein. For example, connected vehicles 206 may transmit charge status, fuel tank readings, braking data, engine operating temperatures, weather data for conditions proximate a vehicle, etc. to computing system 202. For instance, connected vehicles 206 may transmit braking data, such as force applied to the brakes and the duration the brake pedal was pressed. Using that data along with the speed of the vehicle and known wear coefficients for the brake pads/shoe, brake wear may be calculated as an emission.

Data may also include financial data for operating connected vehicles 206 as well as fines and/or penalties that may be imposed for exceeding emissions limits established by regulations.

At stage 306 emissions model 208 may be generated and/or updated. For example, during a first implementation of method 300, computing system 202 may generate emissions model 208. Emissions model 208 may also contain components that are supplied by a manufacture and those components may be used to generate emissions model 208. For instance, the manufacturer of connected vehicles 206 may supply powertrain data via lookup tables or equations that model vehicle performance. Using the manufacturer supplied data, computing system 202 may generate emissions models for each vehicle and/or the overall fleet of vehicles.

Generating emissions model 208 may include using statistical techniques and/or machine learning to generate mathematical models to predict vehicle emissions. For example, using the data, single and/or multivariable regression analysis may be performed to generate emissions model 208. For instances where models already exist, statistical techniques and/or machine learning may be used to refine and/or otherwise improve the predictions generated via emissions model 206.

At stage 308 emissions decay may be modeled and included into emissions model 206. For example, using weather data received at stage 304, wind patterns and/or rain fall may be used to determine an effect on emissions weather may have. For instance, if the wind is blowing from east to west, emissions in a given location may be decreased by a first factor dependent on the wind strength, while emissions in an area to the west may be increases by a second factor. The first and second factors need not be equal. Modeling emissions decay may include modeling rainwater runoff patterns to predict how rainwater may carry particles that land on the ground. For example, rubber from tire wear or leaking fluids from connected vehicles 206 may be carried away by rainwater and modeled as part of stage 308. Thus, the emissions decays modeled in stage 308 may be applied to the models generated in stage 306 to show increases or reductions in emissions.

At stage 310 emissions budgets may be modeled. As disclosed herein, emissions budgets may include many factors and/or levels of granulation. As such, emissions budgets may be generated to account for the overall emissions of connected vehicles 206 as well as a breakdown of how various components of connected vehicles 206 contribute to the overall emissions.

At stage 312 budget predictions may be made. The budget predictions may include emissions budgets and/or financial budgets. For example, at stage 312 emissions budgets for each of connected vehicles 206 may be predicted using the various models generated and an overall emissions budget may be predicted as well. Using the emissions budgets for each of connected vehicles 206 vehicles may be assigned particular trips and/or rerouted as disclosed herein.

Budget predictions may also include financial budgets. During stage 312 costs associated with operation of connected vehicles 206 may be estimated. The costs may include predicting penalties and/or fines that may be assessed for exceeding emissions limits based on the emissions budgets.

Budget predictions may also include utilizing optimization techniques to minimize emissions. For example, during stage 312 Monte Carlo simulations and other optimization techniques may be used to minimize emissions. For example, the various trips connected vehicles 206 may be planned to take may be simulated using different combinations of vehicles, routes, modalities, etc. to determine a plurality of trip plans and vehicle assignments that result in reduced emissions.

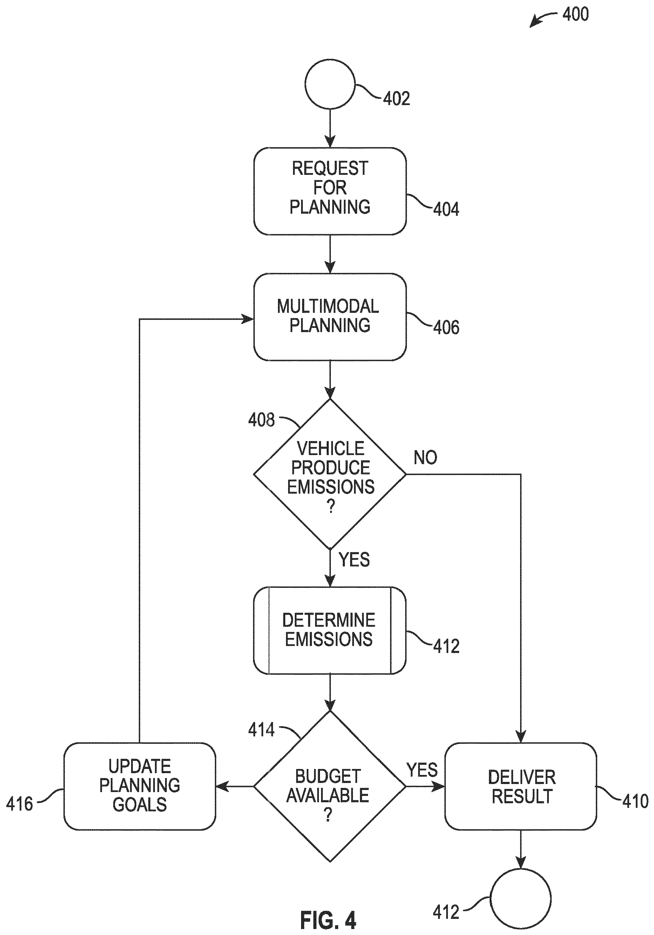

Returning to FIG. 2, multimodal trip planning module 210 may be used to plan and create trip plans for MaaS User 204 and/or connected vehicles 206. FIG. 4 shows a method 400 for trip planning in accordance with at least one example of this disclosure. Method 400 may begin at stage 402 and proceed to stage 404 where a planning request may be received by computer system 202.

The planning request, sometimes referred to as a trip request, may be a request for a single trip and/or a plurality of trips. The planning request may include preferences for modalities, emissions models for the various modalities, route information, and budget information. For example, for a robotaxi, the planning request may include an origin and destination for the trip. The car used by the robotaxi may be one of connected cars 206 and thus one of a fleet of vehicles. The planning request may also be for a plurality of trips. For example, the planning request may be for a plurality of delivery vehicles that may have respective routes to deliver packages. As another example, the planning request may be for a plurality of buses, trains, or other public transit-on-demand modalities that may have respective routes to transport passengers.

At stage 406 using the data in the planning request trip planning may occur. For example, the origin and the destination may be passed as part of the planning request and computer system 202 may generate the route. For a plurality of trip plans, system 202 may generate a plurality of routes and assign respective connected vehicles 206 for each of, or a portion of, each of the plurality of routes. The assignment of vehicles may be based on emissions budgets and financial budgets as disclosed herein.

The route for the trip may be an input as part of the planning request. For example, a particular route may be desired by a MaaS user 204 and the particular route may be passed to computer system 202. Thus, at stage 406 a vehicle from the connected vehicles 206 may be assigned to complete the trip. In addition, for a multimodal trip, various connected vehicles 206 may be assigned to respective segments of the multimodal trip.

Planning the trip, or plurality of trips, may include defining operating parameters for the connected vehicles 206. For example, internal combustion engines may produce more emissions when operated at high speeds (either speed of the vehicle or speed of the engine). As a result, using an equation defining emissions as a function of at least speed, planning the trip may include specifying a speed at which the trip should be conducted.

After a trip is planned, a determination can be made as to how the vehicle used may effect an emissions budget at decision block 408. If the vehicle is a zero-emission vehicle, such as an EV that is charged via solar power, the vehicle may have no effect on an emission budget. If the vehicle does not produce emissions based on the model and/or operating characteristics of the vehicle, the method 400 may proceed to stage 410 where the trip plan may be outputted.

Outputting the trip plan may include providing a listing of the trip plan including directions for a driver. The outputted trip plan may also define operating characteristics of the trip plan such as speed. Outputting the trip plan may also include transmitting an activation signal to an autonomous vehicle. For example, if the trip plan is for a robotaxi to be conducted by an autonomous vehicle, the activation signal may be transmitted to the autonomous vehicle. Upon receiving the activation signal, a controller of the autonomous vehicle may cause the autonomous vehicle to perform the trip.

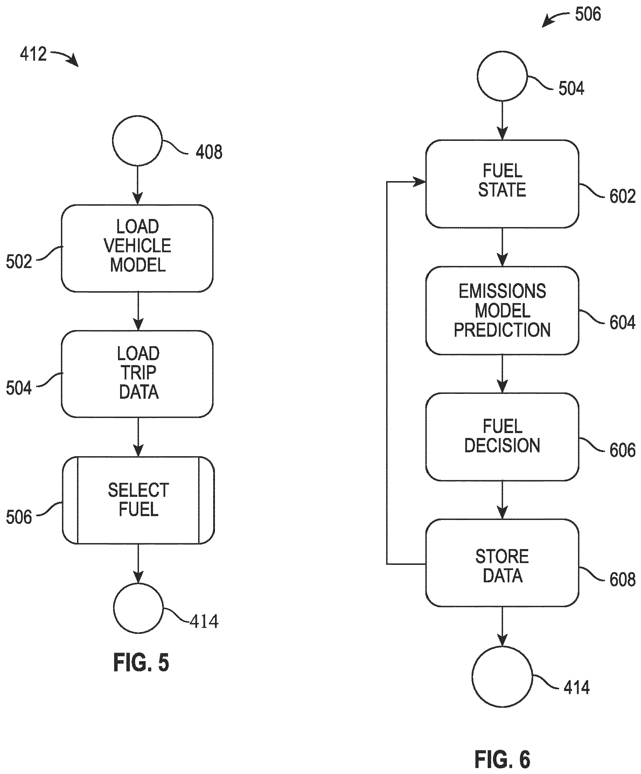

If the vehicle does produce emissions method 400 may proceed to subroutine 412 where emissions may be predicted. FIG. 5 shows subroutine 412 in accordance with at least one example of the present disclosure. Subroutine 412 may begin at stage 502 where one or more vehicle models may be loaded. Loading the vehicle models may include retrieving the vehicles models from a memory of computer system 202. In addition, the vehicle models may be a component of planning request received in stage 404. The vehicle models may be a component of emissions models 208. The vehicle information may also include refueling information, time and/or miles since last refuel/recharge, current state of charge/fuel in the tank, and the modality of the vehicle (i.e., ICE, EV, or hybrid).

At stage 405 trip data may be loaded. The trip data may be retrieved from a memory of computer system 202 or may be generated by computer system 202 as part of planning stage 406. The trip data may include routing information, payload information, such as weight and dimensions, etc. The trip data may further include estimated wait times to pick up and/or drop off passengers/cargo, wait times for traffic (i.e., waiting at intersections, traffic delays, etc.), as well as physical characteristics of the trip. For example, the trip information may include heights of overpasses and/or tunnels the vehicle may encounter.

At subroutine 506, the vehicle model and trip data may be used to select a fuel or modality for the trip. FIG. 6 shows an example of subroutine 506 in accordance with at least one example of this disclosure. Subroutine 506 may begin at stage 602 where a fuel state may be determined. Determining the fuel state may include determining an amount of fuel in a tank and/or charge in a battery. The fuels state may be used to determine if the assigned vehicle has enough charge/fuel to complete the trip. The state of the fuel/charge may be used in considering emissions budgets since if recharging/refueling is necessary, the amount of emissions may increase for a given trip. For example, to recharge a vehicle may include additional emissions charged against a budget due to the burning of fossil fuels to produce the electricity. Thus, it might be wise to select a different vehicle that currently has enough charge to complete the trip. The vehicle with the low charge may be recharged with solar energy as soon as it is available, such as in the morning if the trip is a night trip.

This monitoring of charge and emissions may allow for the distribution of emission to different times in addition to the distribution of emissions among vehicles. For example, if the emissions budget is predicted to be low in the afternoon, charge/refueling can be shifted to take advantage of times when additional budget is available. For trips in the afternoon, cheaper petrol vehicles may be used and/or hybrids can be used in a mixed mode instead of EV only.

Traditional fuels like petrol may be offered in different grades (e.g., different octanes, added bio ethanol in different amounts, etc.) that may be selected for refueling and may have different emissions (e.g., either amount of emissions and/or type of emissions). Electricity may come from renewables or fossil fuels. Hydrogen may be generated using electricity (fossil fuel generated or renewable) or from fossil fuels directly. Thus, each fuel type may have different emissions and charging can be managed and scheduled to offset budget constraints as disclosed herein.

At stage 604 a version of emissions models may be produced. The version may be a new version that uses more recent data for its creations. For example, past data from a similar trip may provide a better estimate for emissions. The similar trip may have been conducted at the same time of day, under the same or similar weather conditions, have the same or similar route, etc. as the planned trip.

Using the emission models the fuel or modality that results in the lowest emissions or at least emissions within a budget limit may be selected at stage 606. For example, instead of using an EV that needs charging, a vehicle with an ICE may be used. In addition, the trip may have multiple segments and different modalities may be selected to conform to a budget constraint. Once the fuel type and/or modalities have been selected, the fuel/modality data may be stored in a memory at stage 608 for use in updating emissions model 208 as discussed herein at least with respect to FIG. 3. After storing the data, subroutine 506 may return to decision block 414.

Returning to FIG. 4, at decision block 414 a determination can be made if budget is available to complete the trip. For example, based on the various models and estimations produced concerning emissions, a determination can be made as to if the emissions for the trip exceed a budget limit. For example, if the trip as planned would release X particles per cubic meter into the atmosphere and the maximum budget for emissions is Y particles per cubic meter, with Y being greater than X, then the trip is within the emissions budget and method 400 may proceed to stage 410 where the trip details may be returned as disclosed herein.

Should X be greater than Y, then the trip may exceed the emissions budget and method 400 may proceed to stage 416 where planning goals may be updated. Updating the planning goals may include storing the data that lead to emissions exceeding the budgeted amount. For example, the vehicle, operation modes, fuel, route chosen, etc. may be stored and used as an input for trip planning as method 400 returns to stage 406 to replan the trip.

In addition, when the emissions exceed the budgeted amount, an associated trip may be canceled. For example, when segments of the associated trip, or the trip itself, cannot be rescheduled and/or adjust to lower emissions for the trip to below the budgeted amount, the trip may be canceled to avoid exceeding the budgeted amount.

As disclosed herein, having budget available may include monetary budgets as well. For example, a trip may exceed an emissions budget and there may be a penalty and/or fine levied if the trip is executed. However, the MaaS 204 may wish to pay the penalty and/or fine and proceed with the trip anyway. Thus, at decision block 414, a financial decision may also be considered and the trip allowed to proceed even if the emissions for the trip exceed the emissions budget.

Returning to FIG. 2, fleet management module 212 may be used to manage connected vehicles 206 as disclosed herein. For example, using multimodal trip planning module 210 a plurality of trips can be simulated to allow for fleet emission control, distribution, and limits adherence. By using the multimodal trip planning module 210, emissions may be taken into account when planning trips.

As disclosed herein, when one or more trips is requested, the emissions for the trip may be predicted using the models, current refueling/recharge, data and the route planned. The emissions predicted may be checked against the emissions budget remaining for additional trips. If the budget is not sufficient, the goals for the multimodal planning algorithm may be updated to exclude this trip with a particular vehicle.

In addition, the system may allow for selection of different vehicles in an attempt to execute the trip within the budget. Thus, fleet management module 212 may be used to distribute different kinds of vehicles to optimize the MaaS User's 204 emission profile in a city, with a prediction component aimed to minimize impact of the MaaS User's 204 operation by triggering emission limits. System 200 may also allow for both static and dynamic reaction to legal action, such as legislation passed and/or new/updated regulations, governing bodies by operating connected vehicles 206 in different modes (e.g. hybrid cars are EV only in a certain area while using the petrol engine to charge the battery in another area).

The systems and method disclosed herein may also allow for multimodal planning by suggesting different modes of transportation to a passenger (e.g., bike instead of taxi). They also allow for faster, but potentially emissions budget stretching, trips that may be sold at a higher rate. In addition, users can be shown the predicted emissions of their trip and be presented with alternatives with a compromise in cost, duration, length, number of legs/vehicles changes, etc.

The various embodiments disclosed herein may be implemented in one or a combination of hardware, firmware, and software. Embodiments may also be implemented as instructions stored on a machine-readable storage device, which may be read and executed by at least one processor to perform the operations described herein. A machine-readable storage device may include any non-transitory mechanism for storing information in a form readable by a machine (e.g., a computer). For example, a machine-readable storage device may include read-only memory (ROM), random-access memory (RAM), magnetic disk storage media, optical storage media, flash-memory devices, and other storage devices and media.

A processor subsystem may be used to execute the instruction on the -readable medium. The processor subsystem may include one or more processors, each with one or more cores. Additionally, the processor subsystem may be disposed on one or more physical devices. The processor subsystem may include one or more specialized processors, such as a graphics processing unit (GPU), a digital signal processor (DSP), a field programmable gate array (FPGA), or a fixed function processor.

Examples, as described herein, may include, or may operate on, logic or a number of components, modules, or mechanisms. Modules may be hardware, software, or firmware communicatively coupled to one or more processors in order to carry out the operations described herein. Modules may be hardware modules, and as such modules may be considered tangible entities capable of performing specified operations and may be configured or arranged in a certain manner. In an example, circuits may be arranged (e.g., internally or with respect to external entities such as other circuits) in a specified manner as a module. In an example, the whole or part of one or more computer systems (e.g., a standalone, client or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations. Accordingly, the term hardware module is understood to encompass a tangible entity, be that an entity that is physically constructed, specifically configured (e.g., hardwired), or temporarily (e.g., transitorily) configured (e.g., programmed) to operate in a specified manner or to perform part or all of any operation described herein. Considering examples in which modules are temporarily configured, each of the modules need not be instantiated at any one moment in time. For example, where the modules comprise a general-purpose hardware processor configured using software; the general-purpose hardware processor may be configured as respective different modules at different times. Software may accordingly configure a hardware processor, for example, to constitute a particular module at one instance of time and to constitute a different module at a different instance of time. Modules may also be software or firmware modules, which operate to perform the methodologies described herein.

Circuitry or circuits, as used in this document, may comprise, for example, singly or in any combination, hardwired circuitry, programmable circuitry such as computer processors comprising one or more individual instruction processing cores, state machine circuitry, and/or firmware that stores instructions executed by programmable circuitry. The circuits, circuitry, or modules may, collectively or individually, be embodied as circuitry that forms part of a larger system, for example, an integrated circuit (IC), system on-chip (SoC), desktop computers, laptop computers, tablet computers, servers, smart phones, etc.

As used in any embodiment herein, the term "logic" may refer to firmware and/or circuitry configured to perform any of the aforementioned operations. Firmware may be embodied as code, instructions or instruction sets and/or data that are hard-coded (e.g., nonvolatile) in memory devices and/or circuitry.

"Circuitry," as used in any embodiment herein, may comprise, for example, singly or in any combination, hardwired circuitry, programmable circuitry, state machine circuitry, logic and/or firmware that stores instructions executed by programmable circuitry. The circuitry may be embodied as an integrated circuit, such as an integrated circuit chip. **In** some embodiments, the circuitry may be formed, at least in part, by the processor circuitry executing code and/or instructions sets (e.g., software, firmware, etc.) corresponding to the functionality described herein, thus transforming a general-purpose processor into a specific-purpose processing environment to perform one or more of the operations described herein. In some embodiments, the processor circuitry may be embodied as a stand-alone integrated circuit or may be incorporated as one of several components on an integrated circuit. In some embodiments, the various components and circuitry of the node or other systems may be combined in a system-on-a-chip (SoC) architecture

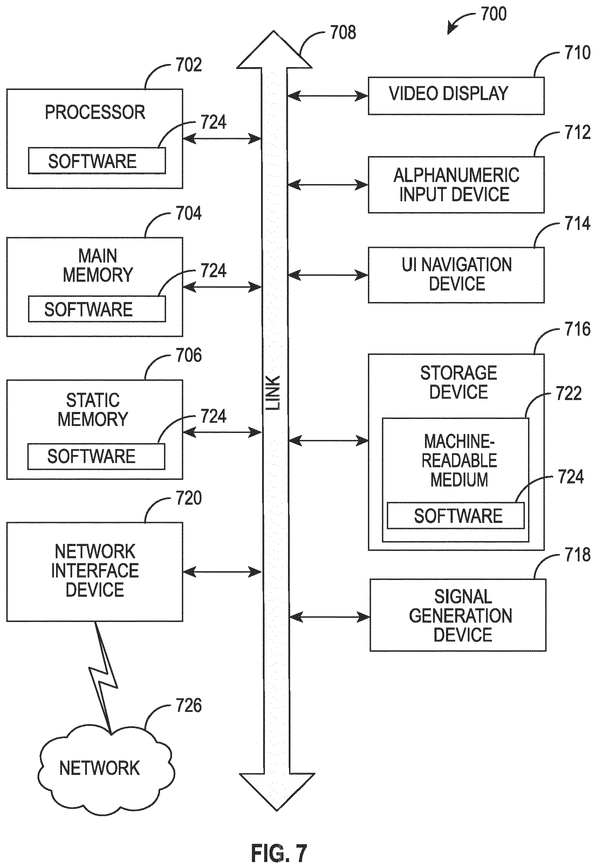

FIG. 7 is a block diagram illustrating a machine in the example form of a computer system 700, such as computer system 202, within which a set or sequence of instructions may be executed to cause the machine to perform any one of the methodologies discussed herein, according to an embodiment. In alternative embodiments, the machine operates as a standalone device or may be connected (e.g., networked) to other machines. In a networked deployment, the machine may operate in the capacity of either a server or a client machine in server-client network environments, or it may act as a peer machine in peer-to-peer (or distributed) network environments. The machine may be a vehicle subsystem, a personal computer (PC), a tablet PC, a hybrid tablet, a personal digital assistant (PDA), a mobile telephone, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein. Similarly, the term "processor-based system" shall be taken to include any set of one or more machines that are controlled by or operated by a processor (e.g., a computer) to individually or jointly execute instructions to perform any one or more of the methodologies discussed herein.

Example computer system 700 includes at least one processor 702 (e.g., a central processing unit (CPU), a graphics processing unit (GPU) or both, processor cores, compute nodes, etc.), a main memory 704 and a static memory 706, which communicate with each other via a link 708 (e.g., bus). The computer system 700 may further include a video display unit 710, an alphanumeric input device 712 (e.g., a keyboard), and a user interface (UI) navigation device 714 (e.g., a mouse). In one embodiment, the video display unit 710, input device 712 and UI navigation device 714 are incorporated into a touch screen display. The computer system 700 may additionally include a storage device 716 (e.g., a drive unit), a signal generation device 718 (e.g., a speaker), a network interface device 720, and one or more sensors (not shown), such as a global positioning system (GPS) sensor, compass, accelerometer, gyrometer, magnetometer, or other sensor.

The storage device 716 includes a machine-readable medium 722 on which is stored one or more sets of data structures and instructions 724 (e.g., software) embodying or utilized by any one or more of the methodologies or functions described herein. The instructions 724 may also reside, completely or at least partially, within the main memory 704, static memory 706, and/or within the processor 702 during execution thereof by the computer system 700, with the main memory 704, static memory 706, and the processor 702 also constituting machine-readable media.

While the machine-readable medium 722 is illustrated in an example embodiment to be a single medium, the term "machine-readable medium" may include a single medium or multiple media (e.g., a centralized or distributed database, and/or associated caches and servers) that store the one or more instructions 724. The term "machine-readable medium" shall also be taken to include any tangible medium that is capable of storing, encoding or carrying instructions for execution by the machine and that cause the machine to perform any one or more of the methodologies of the present disclosure or that is capable of storing, encoding or carrying data structures utilized by or associated with such instructions. The term "machine-readable medium" shall accordingly be taken to include, but not be limited to, solid-state memories, and optical and magnetic media. Specific examples of machine-readable media include non-volatile memory, including but not limited to, by way of example, semiconductor memory devices (e.g., electrically programmable read-only memory (EPROM), electrically erasable programmable read-only memory (EEPROM)) and flash memory devices; magnetic disks such as internal hard disks and removable disks; magneto-optical disks; and CD-ROM and DVD-ROM disks.

The instructions 724 may further be transmitted or received over a communications network 726 using a transmission medium via the network interface device 720 utilizing any one of a number of well-known transfer protocols (e.g., HTTP). Examples of communication networks include a local area network (LAN), a wide area network (WAN), the Internet, mobile telephone networks, plain old telephone (POTS) networks, and wireless data networks (e.g., Bluetooth, Wi-Fi, 3G, and 4G LTE/LTE-A, 5G, DSRC, or Satellite (e.g., low-earth orbit) networks). The term "transmission medium" shall be taken to include any intangible medium that is capable of storing, encoding, or carrying instructions for execution by the machine, and includes digital or analog communications signals or other intangible medium to facilitate communication of such software.

### Additional Notes

The above detailed description includes references to the accompanying drawings, which form a part of the detailed description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A system (202) for vehicle emissions control, the system (202) comprising:
at least one processor (702); and
at least one memory (704) storing instructions that, when executed by the processor (702), cause the processor (702) to perform actions comprising:
receiving a planning request, the planning request including an origin, a destination, and a vehicle to be used for a trip,
creating a trip plan, the trip plan defining a route from the origin to the destination,
determining an emissions output for the vehicle to complete the trip based on the trip plan
determining a budgeted emissions output by determining a decay of emissions based on weather data;
determining whether the emissions output is below the budgeted emissions output,
transmitting the trip plan to a user in response to determining that the emissions output is below the budgeted emissions output,
selecting a new vehicle when the emissions output of the vehicle is not below the budgeted emissions output,
creating a new trip plan using the new vehicle,
determining whether an emissions output of the new vehicle for the new trip plan is below the budgeted emissions output, and
transmitting the new trip plan to the user.

2. The system (202) of claim 1, wherein determining the emissions output is below the budgeted emissions output includes additional actions comprising determining a total emissions output is below the budgeted emissions output.

3. The system (202) of one of the previous claims, wherein determining the emissions output is below the budgeted emissions output includes additional actions comprising determining an exhaust emissions output is below the budgeted emissions output.

4. The system (202) of one of the previous claims, wherein determining the emissions output is below the budgeted emissions output includes additional actions comprising determining a localized emissions output is below a localized budgeted emissions.

5. The system (202) of one of the previous claims, wherein creating the trip plan includes additional actions comprising defining operating parameters for the vehicle while traveling the route.

6. The system (202) of one of the previous claims, wherein the instructions comprise additional instructions that, upon execution by the processor, cause the processor to perform additional actions comprising updating the budgeted emissions output after completion of the trip plan.

7. A method (400) for vehicle emissions control, the method (400) comprising:
receiving (404), at a computing device, a planning request, the planning request including an origin, a destination, and a vehicle to be used for a trip;
creating, by the computing device, a trip plan, the trip plan defining a route from the origin to the destination;
determining (412), by the computing device, an emissions output for the vehicle to complete the trip based on the trip plan;
determining a budgeted emissions output by determining a decay of emissions based on weather data;
determining (414), by the computing device, whether the emissions output is below the budgeted emissions output;
transmitting (410), by the computing device, the trip plan to a user in response to determining that the emissions output is below the budgeted emissions output;
selecting (416), by the computing device, a new vehicle when the emissions output of the vehicle is not below the budgeted emissions output;
creating (412), by the computing device, a new trip plan using the new vehicle;
determining (414), by the computing device, whether an emissions output of the new vehicle for the new trip plan is below the budgeted emissions output; and
transmitting (414), by the computing device, the new trip plan to the user.

8. The method (400) of claim 7, wherein determining (414) the emissions output is below the budgeted emissions output includes determining that a total emissions output is below the budgeted emissions output.

9. The method (400) of one of the claims 7-8, wherein determining (414) the emissions output is below the budgeted emissions output includes determining that an exhaust emissions output is below the budgeted emissions output.

10. The method (400) of one of the claims 7-9, wherein determining (414) the emissions output is below the budgeted emissions output includes determining that a localized emissions output is below a localized budgeted emissions output.

11. The method (400) of one of the claims 7-10, wherein creating (412) the trip plan includes defining operating parameters for the vehicle while traveling the route.

12. The method (400) of one of the claims 7-11, further comprising updating the budgeted emissions output after completion of the trip plan.

13. A system (202) for emissions control for a fleet of vehicles, the system (202) comprising:
at least one processor (702); and
at least one memory (704) storing instructions that, when executed by the processor (702), cause the processor (702) to perform actions comprising:
receiving a planning request, the planning request including a plurality of trip plans, each of the trip plans including an origin, a destination, and a vehicle from the fleet of vehicles to be used for a trip associated with the vehicle;
determining an emissions output for the fleet of vehicles to execute the plurality of trip plans;
determining a budgeted emissions output by determining a decay of emissions based on weather data;
determining that the emissions output is below the budgeted emissions output;
transmitting each of the plurality of trip plans to a respective user in response to determining that the emissions output is below the budgeted emissions output;
selecting a new vehicle when the emissions output of the vehicle is not below the budgeted emissions output;
creating a new trip plan using the new vehicle;
determining whether an emissions output of the new vehicle for the new trip plan is below the budgeted emissions output; and
transmitting the new trip plan to the user.

14. A method (400) for emissions control for a fleet of vehicles, the method (400) comprising:
receiving (404), at a computing device, a planning request, the planning request including a plurality of trip plans, each of the plurality of trip plans including an origin, a destination, and a vehicle from the fleet of vehicles to be used for a trip associated with the vehicle;
determining (412), by the computing device, an emissions output for the fleet of vehicles to execute the plurality of trip plans;
determining, by the computing device, a budgeted emissions output by determining a decay of emissions based on weather data;
determining (414), by the computing device, whether the emissions output of the vehicle is below the budgeted emissions output;
transmitting (410), by the computing device, the plurality of trip plans to a user in response to determining that the emissions output is below the budgeted emissions output;
selecting (416), by the computing device, a new vehicle when the emissions output of the vehicle is not below the budgeted emissions output;
creating (406), by the computing device, a new trip plan using the new vehicle;
determining (414), by the computing device, whether an emissions output of the new vehicle for the new trip plan is below the budgeted emissions output; and
transmitting (410), by the computing device, the new trip plan to the user.

## Patentansprüche

1. System (202) zur Fahrzeugemissionskontrolle, wobei das System (202) umfasst:
mindestens einen Prozessor (702); und
mindestens einen Speicher (704), der Anweisungen speichert, die bei Ausführung durch den Prozessor (702) den Prozessor (702) veranlassen, Aktionen durchzuführen, die Folgendes umfassen:
Empfangen einer Planungsanforderung, wobei die Planungsanforderung einen Ausgangsort, einen Zielort und ein für eine Fahrt zu verwendendes Fahrzeug aufweist,
Erstellen eines Fahrtenplans, wobei der Fahrtenplan eine Route vom Ausgangsort zum Zielort definiert,
Bestimmen eines Emissionsausstoßes für das Fahrzeug bis zur Beendigung der Fahrt basierend auf dem Fahrtenplan,
Bestimmen eines budgetierten Emissionsausstoßes durch Bestimmen einer Abnahme der Emissionen basierend auf Wetterdaten;
Bestimmen, ob der Emissionsausstoß unter dem budgetierten Emissionsausstoß liegt,
Übertragen des Fahrtenplans an einen Benutzer als Reaktion auf das Bestimmen, dass der Emissionsausstoß unter dem budgetierten Emissionsausstoß liegt,
Auswählen eines neuen Fahrzeugs, wenn der Emissionsausstoß des Fahrzeugs nicht unter dem budgetierten Emissionsausstoß liegt,
Erzeugen eines neuen Fahrtenplans mit dem neuen Fahrzeug, Bestimmen, ob ein Emissionsausstoß des neuen Fahrzeugs für den neuen Fahrtenplan unter dem budgetierten Emissionsausstoß liegt, und
Übertragen des neuen Fahrtenplans an den Benutzer.

2. System (202) nach Anspruch 1, wobei das Bestimmen, dass der Emissionsausstoß unter dem budgetierten Emissionsausstoß liegt, zusätzliche Aktionen beinhaltet, die umfassen zu bestimmen, dass ein Gesamt-Emissionsausstoß unter dem budgetierten Emissionsausstoß liegt.

3. System (202) nach einem der vorhergehenden Ansprüche, wobei das Bestimmen, dass der Emissionsausstoß unter dem budgetierten Emissionsausstoß liegt, zusätzliche Aktionen beinhaltet, die umfassen zu bestimmen, dass ein Abgasemissionsausstoß unter dem budgetierten Emissionsausstoß liegt.

4. System (202) nach einem der vorhergehenden Ansprüche, wobei das Bestimmen, dass der Emissionsausstoß unter dem budgetierten Emissionsausstoß liegt, zusätzliche Aktionen beinhaltet, die umfassen zu bestimmen, dass ein lokalisierter Emissionsausstoß unter einem lokalisierten budgetierten Emissionsausstoß liegt.

5. System (202) nach einem der vorhergehenden Ansprüche, wobei das Erstellen des Fahrtenplans zusätzliche Aktionen beinhaltet, die umfassen, Betriebsparameter für das Fahrzeug während des Fahrens auf der Route zu definieren.

6. System (202) nach einem der vorhergehenden Ansprüche, wobei die Anweisungen zusätzliche Anweisungen umfassen, die bei Ausführung durch den Prozessor den Prozessor veranlassen, zusätzliche Aktionen durchzuführen, die umfassen, den budgetierten Emissionsausstoß nach Abschluss des Fahrtenplans zu aktualisieren.

7. Verfahren (400) zur Fahrzeugemissionskontrolle, wobei das Verfahren (400) umfasst:
Empfangen (404), an einer Rechenvorrichtung, einer Planungsanforderung, wobei die Planungsanforderung einen Ausgangsort, einen Zielort und ein für eine Fahrt zu verwendendes Fahrzeug aufweist;
Erstellen, durch die Rechenvorrichtung, eines Fahrtenplans, wobei der Fahrtenplan eine Route vom Ausgangsort zum Zielort definiert;
Bestimmen (412), durch die Rechenvorrichtung, eines Emissionsausstoßes für das Fahrzeug bis zur Beendigung der Fahrt basierend auf dem Fahrtenplan;
Bestimmen eines budgetierten Emissionsausstoßes durch Bestimmen einer Abnahme der Emissionen basierend auf Wetterdaten;
Bestimmen (414), durch die Rechenvorrichtung, ob der Emissionsausstoß unter dem budgetierten Emissionsausstoß liegt;
Übertragen (410), durch die Rechenvorrichtung, des Fahrtenplans an einen Benutzer als Reaktion auf das Bestimmen, dass der Emissionsausstoß unter dem budgetierten Emissionsausstoß liegt;
Auswählen (416), durch die Rechenvorrichtung, eines neuen Fahrzeugs, wenn der Emissionsausstoß des Fahrzeugs nicht unter dem budgetierten Emissionsausstoß liegt;
Erzeugen (412), durch die Rechenvorrichtung, eines neuen Fahrtenplans mit dem neuen Fahrzeug;
Bestimmen (414), durch die Rechenvorrichtung, ob ein Emissionsausstoß des neuen Fahrzeugs für den neuen Fahrtenplan unter dem budgetierten Emissionsausstoß liegt; und
Übertragen (414), durch die Rechenvorrichtung, des neuen Fahrtenplans an den Benutzer.

8. Verfahren (400) nach Anspruch 7, wobei das Bestimmen (414), dass der Emissionsausstoß unter dem budgetierten Emissionsausstoß liegt, beinhaltet zu bestimmen, dass ein Gesamt-Emissionsausstoß unter dem budgetierten Emissionsausstoß liegt.

9. Verfahren (400) nach einem der Ansprüche 7-8, wobei das Bestimmen (414), dass der Emissionsausstoß unter dem budgetierten Emissionsausstoß liegt, beinhaltet zu bestimmen, dass ein Abgasemissionsausstoß unter dem budgetierten Emissionsausstoß liegt.

10. Verfahren (400) nach einem der Ansprüche 7-9, wobei das Bestimmen (414), dass der Emissionsausstoß unter dem budgetierten Emissionsausstoß liegt, beinhaltet zu bestimmen, dass ein lokalisierter Emissionsausstoß unter einem lokalisierten budgetierten Emissionsausstoß liegt.

11. Verfahren (400) nach einem der Ansprüche 7-10, wobei das Erstellen (412) des Fahrtenplans beinhaltet, Betriebsparameter für das Fahrzeug während des Fahrens auf der Route zu definieren.

12. Verfahren (400) nach einem der Ansprüche 7-11, ferner umfassend, den budgetierten Emissionsausstoß nach Abschluss des Fahrtenplans zu aktualisieren.

13. System (202) zur Emissionskontrolle für eine Fahrzeugflotte, wobei das System (202) umfasst:
mindestens einen Prozessor (702); und
mindestens einen Speicher (704), der Anweisungen speichert, die bei Ausführung durch den Prozessor (702) den Prozessor (702) veranlassen, Aktionen durchzuführen, die Folgendes umfassen:
Empfangen einer Planungsanforderung, wobei die Planungsanforderung eine Vielzahl von Fahrtenplänen aufweist, wobei jeder der Fahrtenpläne einen Ausgangsort, einen Zielort und ein Fahrzeug aus der Fahrzeugflotte, das für eine mit dem Fahrzeug verknüpfte Fahrt verwendet werden soll, aufweist;
Bestimmen eines Emissionsausstoßes für die Fahrzeugflotte für die Ausführung der Vielzahl von Fahrtenplänen;
Bestimmen eines budgetierten Emissionsausstoßes durch Bestimmen einer Abnahme der Emissionen basierend auf Wetterdaten;
Bestimmen, dass der Emissionsausstoß unter dem budgetierten Emissionsausstoß liegt;
Übertragen jedes der Vielzahl von Fahrtenplänen an einen jeweiligen Benutzer als Reaktion auf das Bestimmen, dass der Emissionsausstoß unter dem budgetierten Emissionsausstoß liegt;
Auswählen eines neuen Fahrzeugs, wenn der Emissionsausstoß des Fahrzeugs nicht unter dem budgetierten Emissionsausstoß liegt;
Erzeugen eines neuen Fahrtenplans mit dem neuen Fahrzeug;
Bestimmen, ob ein Emissionsausstoß des neuen Fahrzeugs für den neuen Fahrtenplan unter dem budgetierten Emissionsausstoß liegt; und
Übertragen des neuen Fahrtenplans an den Benutzer.

14. Verfahren (400) zur Emissionskontrolle für eine Fahrzeugflotte, wobei das Verfahren (400) umfasst:
Empfangen (404), an einer Rechenvorrichtung, einer Planungsanforderung, wobei die Planungsanforderung eine Vielzahl von Fahrtenplänen aufweist, wobei jeder der Vielzahl von Fahrtenplänen einen Ausgangsort, einen Zielort und ein Fahrzeug aus der Fahrzeugflotte, das für eine mit dem Fahrzeug verknüpfte Fahrt verwendet werden soll, aufweist;
Bestimmen (412), durch die Rechenvorrichtung, eines Emissionsausstoßes für die Fahrzeugflotte für die Ausführung der Vielzahl von Fahrtenplänen;
Bestimmen, durch die Rechenvorrichtung, eines budgetierten Emissionsausstoßes durch Bestimmen einer Abnahme der Emissionen basierend auf Wetterdaten;
Bestimmen (414), durch die Rechenvorrichtung, ob der Emissionsausstoß des Fahrzeugs unter dem budgetierten Emissionsausstoß liegt;
Übertragen (410), durch die Rechenvorrichtung, der Vielzahl von Fahrtenplänen an einen Benutzer als Reaktion auf das Bestimmen, dass der Emissionsausstoß unter dem budgetierten Emissionsausstoß liegt;
Auswählen (416), durch die Rechenvorrichtung, eines neuen Fahrzeugs, wenn der Emissionsausstoß des Fahrzeugs nicht unter dem budgetierten Emissionsausstoß liegt;
Erzeugen (406), durch die Rechenvorrichtung, eines neuen Fahrtenplans mit dem neuen Fahrzeug;
Bestimmen (414), durch die Rechenvorrichtung, ob ein Emissionsausstoß des neuen Fahrzeugs für den neuen Fahrtenplan unter dem budgetierten Emissionsausstoß liegt; und
Übertragen (410), durch die Rechenvorrichtung, des neuen Fahrtenplans an den Benutzer.

## Revendications

1. Système (202) de contrôle des émissions d'un véhicule, le système (202) comprenant :
au moins un processeur (702) ; et
au moins une mémoire (704) stockant des instructions qui, lorsqu'elles sont exécutées par le processeur (702), amènent le processeur (702) à réaliser des actions comprenant :
la réception d'une demande de planification, la demande de planification incluant une origine, une destination, et un véhicule à utiliser pour un voyage,
la création d'un plan de voyage, le plan de voyage définissant un itinéraire depuis l'origine jusqu'à la destination,
la détermination d'une production d'émissions pour le véhicule pour achever le voyage sur la base du plan de voyage
la détermination d'une production d'émissions budgétées en déterminant une désintégration des émissions sur la base de données météorologiques ;
la détermination de si la production d'émissions est inférieure à la production d'émissions budgétées,
la transmission du plan de voyage à un utilisateur en réponse à la détermination du fait que la production d'émissions est inférieure à la production d'émissions budgétées,
la sélection d'un nouveau véhicule lorsque la production d'émissions du véhicule n'est pas inférieure à la production d'émissions budgétées,
la création d'un nouveau plan de voyage utilisant le nouveau véhicule,
la détermination de si une production d'émissions du nouveau véhicule pour le nouveau plan de voyage est inférieure à la production d'émissions budgétées, et
la transmission du nouveau plan de voyage à l'utilisateur.

2. Système (202) selon la revendication 1, dans lequel la détermination que la production d'émissions est inférieure à la production d'émissions budgétées inclut des actions supplémentaires comprenant la détermination qu'une production d'émissions totales est inférieure à la production d'émissions budgétées.

3. Système (202) selon l'une des revendications précédentes, dans lequel la détermination que la production d'émissions est inférieure à la production d'émissions budgétées inclut des actions supplémentaires inclut la détermination qu'une production d'émissions d'échappement est inférieure à la production d'émissions budgétées.

4. Système (202) selon l'une des revendications précédentes, dans lequel la détermination que la production d'émissions est inférieure à la production d'émissions budgétées inclut des actions supplémentaires comprenant la détermination qu'une production d'émissions localisées est inférieure à des émissions budgétées localisées.

5. Système (202) selon l'une des revendications précédentes, dans lequel la création du plan de voyage inclut des actions supplémentaires comprenant la définition de paramètres de fonctionnement pour le véhicule quand il parcourt l'itinéraire.

6. Système (202) selon l'une des revendications précédentes, dans lequel les instructions comprennent des instructions supplémentaires qui, lors de l'exécution par le processeur, amènent le processeur à réaliser des actions supplémentaires comprenant la mise à jour des émissions budgétées produites après achèvement du plan de voyage.

7. Procédé (400) de contrôle des émissions d'un véhicule, le procédé (400) comprenant :
la réception (404), au niveau d'un dispositif informatique, d'une demande de planification, la demande de planification incluant une origine, une destination, et un véhicule à utiliser pour un voyage ;
la création, par le dispositif informatique, d'un plan de voyage, le plan de voyage définissant un itinéraire depuis l'origine jusqu'à la destination ;
la détermination (412), par le dispositif informatique, d'une production d'émissions pour le véhicule pour achever le voyage sur la base du plan de voyage ;
la détermination d'une production d'émissions budgétées en déterminant une désintégration des émissions sur la base de données météorologiques ;
la détermination (414), par le dispositif informatique, de si la production d'émissions est inférieure à la production d'émissions budgétées ;
la transmission (410), par le dispositif informatique, du plan de voyage à un utilisateur en réponse à la détermination du fait que la production d'émissions est inférieure à la production d'émissions budgétées ;
la sélection (416), par le dispositif informatique, d'un nouveau véhicule lorsque la production d'émissions du véhicule n'est pas inférieure à la production d'émissions budgétées ;
la création (412), par le dispositif informatique, d'un nouveau plan de voyage utilisant le nouveau véhicule ;
la détermination (414), par le dispositif informatique, de si une production d'émissions du nouveau véhicule pour le nouveau plan de voyage est inférieure à la production d'émissions budgétées ; et
la transmission (414), par le dispositif informatique, du nouveau plan de voyage à l'utilisateur.

8. Procédé (400) selon la revendication 7, dans lequel la détermination (414) que la production d'émissions est inférieure à la production d'émissions budgétées inclut la détermination qu'une production d'émissions totales est inférieure à la production d'émissions budgétées.

9. Procédé (400) selon l'une des revendications 7 à 8, dans lequel la détermination (414) que la production d'émissions est inférieure à la production d'émissions budgétées inclut la détermination qu'une production d'émissions d'échappement est inférieure à la production d'émissions budgétées.

10. Procédé (400) selon l'une des revendications 7 à 9, dans lequel la détermination (414) que la production d'émissions est inférieure à la production d'émissions budgétées inclut la détermination qu'une production d'émissions localisées est inférieure à la production d'émissions budgétées localisées.

11. Procédé (400) selon l'une des revendications 7 à 10, dans lequel la création (412) du plan de voyage inclut la définition de paramètres de fonctionnement pour le véhicule quand il parcourt l'itinéraire.

12. Procédé (400) selon l'une des revendications 7 à 11, comprenant en outre la mise à jour des émissions budgétées produites après achèvement du plan de voyage.

13. Système (202) de contrôle des émissions pour une flotte de véhicules, le système (202) comprenant :
au moins un processeur (702) ; et
au moins une mémoire (704) stockant des instructions qui, lorsqu'elles sont exécutées par le processeur (702), amènent le processeur (702) à réaliser des actions comprenant :
la réception d'une demande de planification, la demande de planification incluant une pluralité de plans de voyage, chacun des plans de voyage incluant une origine, une destination, et un véhicule de la flotte de véhicules à utiliser pour un voyage associé au véhicule ;
la détermination d'une production d'émissions pour la flotte de véhicules pour exécuter la pluralité de plans de voyage ;
la détermination d'une production d'émissions budgétées en déterminant une désintégration des émissions sur la base de données météorologiques ;
la détermination que la production d'émissions est inférieure à la production d'émissions budgétées ;
la transmission de chaque plan de la pluralité de plans de voyage à un utilisateur respectif en réponse à la détermination du fait que la production d'émissions est inférieure à la production d'émissions budgétées ;
la sélection d'un nouveau véhicule lorsque la production d'émissions du véhicule n'est pas inférieure à la production d'émissions budgétées ;
la création d'un nouveau plan de voyage utilisant le nouveau véhicule ;
la détermination de si une production d'émissions du nouveau véhicule pour le nouveau plan de voyage est inférieure à la production d'émissions budgétées ; et
la transmission du nouveau plan de voyage à l'utilisateur.

14. Procédé (400) de contrôle des émissions pour une flotte de véhicules, le procédé (400) comprenant :
la réception (404), au niveau d'un dispositif informatique, d'une demande de planification, la demande de planification incluant une pluralité de plans de voyage, chaque plan de la pluralité de plans de voyage incluant une origine, une destination, et un véhicule de la flotte de véhicules à utiliser pour un voyage associé au véhicule ;
la détermination (412), par le dispositif informatique, d'une production d'émissions pour la flotte de véhicules pour exécuter la pluralité de plans de voyage ;
la détermination, par le dispositif informatique, d'une production d'émissions budgétées en déterminant une désintégration des émissions sur la base de données météorologiques ;
la détermination (414), par le dispositif informatique, de si la production d'émissions du véhicule, est inférieure à la production d'émissions budgétées ;
la transmission (410), par le dispositif informatique, de la pluralité de plans de voyage à un utilisateur en réponse à la détermination du fait que la production d'émissions est inférieure à la production d'émissions budgétées ;
la sélection (416), par le dispositif informatique, d'un nouveau véhicule lorsque la production d'émissions du véhicule n'est pas inférieure à la production d'émissions budgétées ;
la création (406), par le dispositif informatique, d'un nouveau plan de voyage utilisant le nouveau véhicule ;
la détermination (414), par le dispositif informatique, de si une production d'émissions du nouveau véhicule pour le nouveau plan de voyage est inférieure à la production d'émissions budgétées ; et
la transmission (410), par le dispositif informatique, du nouveau plan de voyage à l'utilisateur.
